(19) Europäisches Patentamt
European Patent Office
Office européen des brevets

(11) **EP 3 745 150 B1**

(12) **EUROPEAN PATENT SPECIFICATION**

(45) Date of publication and mention
of the grant of the patent:
**08.11.2023 Bulletin 2023/45**

(21) Application number: **19176730.0**

(22) Date of filing: **27.05.2019**

(51) International Patent Classification (IPC):
**G01R 31/367** (2019.01)    **G01R 31/392** (2019.01)

(52) Cooperative Patent Classification (CPC):
**G01R 31/392; G01R 31/367;** G01R 31/374

(54) **METHOD AND DEVICE FOR DETERMINING THE DEGRADATION OF A BATTERY MODULE OR BATTERY CELL**

VERFAHREN UND VORRICHTUNG ZUR BESTIMMUNG DER VERSCHLECHTERUNG EINES BATTERIEMODULS ODER EINER BATTERIEZELLE

PROCÉDÉ ET DISPOSITIF POUR DÉTERMINER LA DÉGRADATION D'UN MODULE DE BATTERIE OU D'UNE CELLULE DE BATTERIE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**02.12.2020 Bulletin 2020/49**

(73) Proprietor: **Siemens Aktiengesellschaft**
**80333 München (DE)**

(72) Inventors:
• **Fenech, Kristian**
**1015 Budapest (HU)**

• **Fischer, Hanna**
**8000 Szekesfehervar (HU)**
• **Balazs, Gergely György**
**1034 Budapest (HU)**

(74) Representative: **Siemens Patent Attorneys**
**Postfach 22 16 34**
**80506 München (DE)**

(56) References cited:
**WO-A1-2019/017991    US-A1- 2016 349 330**
**US-A1- 2017 104 332    US-A1- 2019 113 577**

**Description**

The invention relates to a method and a device for determining the degradation of a battery module or battery cell.

The problem of battery health management is now becoming a more significant issue as electric mobility and large-scale battery systems for grid level energy storage become increasingly prevalent. The nature of these large systems typically renders measurement of current levels of health difficult and costly.

The health of a battery indicates in-depth details about battery aging effects like the remaining absolute usage time, wherein the aging effects are caused for instance by the number of charging cycles, the physical battery age, temperatures at operation and charging of the battery or charging and discharging (i.e. energy delivery) profiles.

In prior art, health degradation in batteries is typically measured at the individual cell level in a laboratory environment and can be determined by a measurement of the open circuit voltage (OCV) of a battery cell, incremental capacity analysis (ICA) or impedance spectroscopy methods to form inputs to Fuzzy logic systems or predetermined look-up tables. Relevant prior art is disclosed in US 2016/349330 A1, US 2017/104332 A1, WO 2019/017991 A1 and US 2019/113577 A1, where a predicted temperature and a standard deviation using a machine learning model is calculated, and a degradation of a battery module using predicted temperature, a standard deviation and the actual temperature is determined.

The problem to be solved is to estimate the level of degradation in a battery module or battery cell health by an in-situ measurement method.

The problem is solved by a method for determining the degradation of a battery module or a battery cell as defined in independent claim 1.

The load parameter set can be any set of parameters which accurately describe the load which is being powered by the battery module.

The invention has its merit in providing the capability to use in-situ-measurements for the determination of the degradation of a battery module, which easily can be made without manual interaction with the battery module or cell and which can be performed outside a laboratory testing environment. Thus, reductions in cost and downtime of a respective system can be obtained.

Such a technique could be applied to systems in which temperature can be used as a substitute for the exact knowledge of the level of degradation in a system.

The notion of health of a battery module or a battery cell can be derived by a localized temperature within a battery pack as a function $T(x,t)$, where the input $x$ is a vector comprised of the dedicated measurements and $t$ is the time.

In a further development of the invention it is intended that the battery parameter set, the load parameter set and the environmental parameter set are captured in-situ, i.e. during energy delivery (discharging) of the battery module or battery cell.

The determination of the degradation of a battery module is performed by simple in-situ-measurements, and thus, the lifetime of the battery module can be determined efficiently.

In a further development of the invention it is intended that the battery parameter set comprises at least one parameter related to at least one voltage and/or at least one current of the battery module or at least one cell of the battery module.

A voltage or rather a current of the battery module or cell can accurately describe the load which is being powered by the battery module and moreover being captured easily and automatically by respective sensors.

In a further development of the invention it is intended that the electric load comprises an inverter, and the load parameter set comprises a parameter related to the power consumption of the inverter.

Thus, AC loads can also be applied and the conversion efficiency of the inverter is additionally included to obtain a high precision at the determination of the degradation.

In a further development of the invention it is intended that the electric load comprises an electric motor, and the load parameter set comprises at least one parameter related to at least one current, at least one voltage, a rotational speed, a magnetic flux and/or a motor torque of the electric motor.

The currents can be for instance an AC current (RMS), a d-axis current, a q-axis current and/or a DC current of the motor.

This load parameter set provides an accurate feature set in which the battery temperature may be estimated for a battery which is in use in an electric vehicle.

The d/q transformation, also referred to as dq, dq0 and Park transformation, serves to convert three-phase quantities, such as in a three-phase machine with the axes U, V, W, into a two-axis coordinate system with the axes d and q.

It is part of the mathematical basics of vector control of three-phase machines and describes one of several possible space vector representations. In contrast to the related Clarke transformation, the d/q coordinate system rotates in the stationary case with the rotor and the value pair d/q then represents time-constant quantities.

A three-phase system is described in the complex plane by three coordinates U, V, W, each offset by an angle of 120°. They correspond to the three coils of the stationary stator of a rotary field machine, whereby by definition the axis U coincides with the real axis, as shown in the first figure of the fixed $\alpha\beta$-coordinate system of the Clarke transformation. Currents flowing through these coils are always 0 in total for a symmetrical three-phase system.

In the d/q transformation, the coordinate system with the mutually perpendicular axes d and q with the angular frequency is co-rotated with the rotor. Thus, the rotating field at constant speed in the form of two temporally constant quantities d and q can be described. The value d represents the magnetic flux density of the magnetic excitation in the rotor, and q is an expression of the torque generated by the rotor. Time changes such as the speed or torque fluctuations result in changes in time of d or q. The advantage of the transformation is that induction machines can be controlled with a PI controller just as easily as DC machines.

In order to rotate the d/q coordinate system with the correct angular velocity and phase angle with the rotor, it is necessary to know the exact position in the form of the angle of the rotor. This information, which is essential for the transformation, can be obtained with sensors additionally mounted on the machine, such as Hall sensors or optical sensors, or by means of feedback such as the evaluation of the electromotive force (EMF) on the stator winding.

The transformation is not limited to the electric currents but can be applied analogously for all other electrical quantities such as the occurring electrical voltages or the magnetic flux density.

In a further development of the invention it is intended that the environmental parameter set comprises at least one parameter related to an ambient air temperature in proximity of the battery module.

Thus, the degradation can be calculated in an easy way.

In a further development of the invention it is intended that the machine learning model is a random forest regression tree.

A temperature $T(x,t)$ can be determined through a machine learning method with a Random Forest Regression tree model, which is built using historic data from the battery usage in known nominal state with low amounts of degradation compared to an unused pack.

Thus, the degradation can be calculated in an easy and reliable way.

According to the invention it is intended that a change over the time of a probability of measuring the actual module or cell temperature $T_{act}$, which is normal distributed, is an indicator for the degradation of the battery module or battery cell.

$Pr(X = T_{act})$ is the probability of measuring an module or cell temperature $T_{act}$ with a given normal distribution $X \sim \mathcal{N}(T_{pred}, \sigma_T)$, where $X$ is a normal distributed random variable with the mean $T_{pred}$ and the standard deviation $\sigma_T$.

The change over time of the probability $Pr(X = T_{act})$ is an indicator for the degradation of the battery module or cell, because $X$ is a normal distribution of the predicted temperature $T_{pred}$, derived from observing the actual temperature $T_{act}$.

Degradation is most commonly associated with increased resistance and therefore increased joule heating. Thus, the degradation can be derived from the actual module or cell temperature.

If the probablity of observing $T_{act}$ is very low, then the term $Pr(X = T_{act})$ will go to zero or some very small positive value and the degradation will only increase by a large amount.

$$\left(1 - Pr(X = T_{act})\right) \sim 1$$

Further, if the probablity of observing such a temperature on a non-degraded battery is very high, the term can be formulated:

$$\left(1 - Pr(X = T_{act})\right) \sim 0$$

The objective of the invention is also obtained by a device for determining the degradation of a battery module or a battery cell as defined in independent claim 8.

The invention will be explained in more detail with reference to an embodiment shown in the accompanying drawings. In the drawings shows:

Fig. 1    a schematic illustration of an embodiment of the device according to the invention,

Fig. 2    a schematic illustration of an embodiment of the method according to the invention,

Fig. 3    a flowchart of the steps of the method of Fig. 2.

It is clear, that further not shown parts are necessary for the operation of a device, e.g. sensor devices, driver circuitries, electric connection to a power supply and electronic control components but also mechanical parts, like housings or fastening materials. For the sake of better understanding these parts are not illustrated and described.

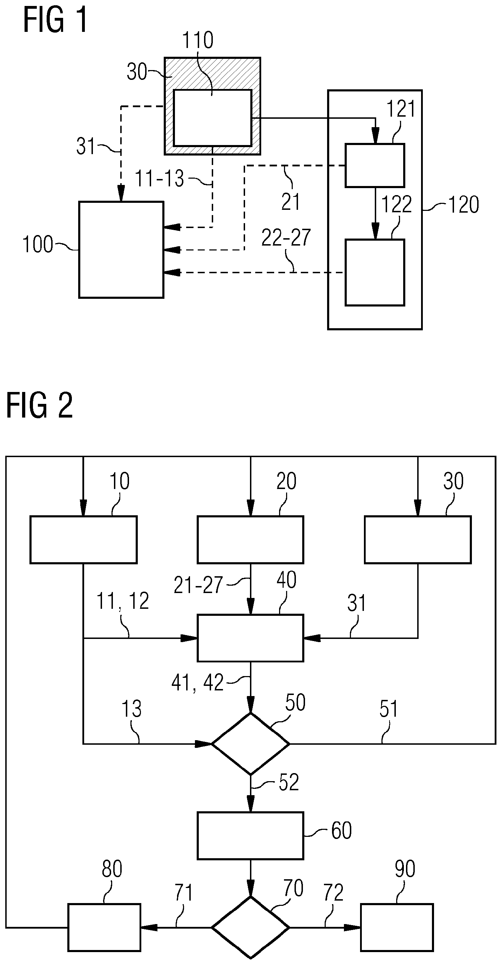

**Fig. 1** shows a schematic illustration of an embodiment of a device according to the invention with a device 100 for determining the degradation of a battery module 110 or a battery cell.

The battery module 110 is configured to deliver energy to an electric load 120.

The electric load comprises an inverter 121 and an electric motor 122, wherein the inverter 121 controls and supplies the motor 122.

The device 100 is configured to capture a battery parameter set 10 including a battery module/ cell temperature 11, a battery module/ cell voltage 12 and a battery module/ cell current 13 from the battery module 110 or battery cell.

Moreover, the device 100 is configured to capture a load parameter set 20 from the inverter 121 including an inverter power consumption 21.

Further, the device 100 is configured to capture the load parameter set 20 from the motor 122 including an AC current 22 (RMS), a d-axis current 23, a q-axis current 24, a DC current 25, a rotational speed 26 and a motor torque 27.

The device 100 is also configured to capture an environmental parameter set 30 in proximity of the battery module 110/ cell including an ambient air temperature 31.

Capturing means can be adequate sensors.

A battery monitor device 100 is configured to carry out the method according to the invention, which is explained in the following.

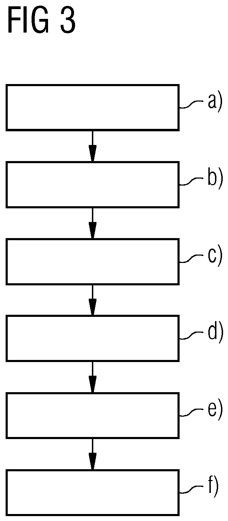

**Fig. 2** and **Fig. 3** show a schematic illustration of an embodiment of the method according to the invention.

Following steps are comprised by the method:

a) Capturing a battery parameter set 10 comprising an actual temperature 11 of the battery module 110,

b) Capturing a load parameter set 20 of the load 120,

c) Capturing an environmental parameter set 30 of the environment of the battery module 110,

d) Setup and training a machine learning model 40 with the battery parameter set 10, the load parameter set 20 and the environmental parameter set 30,

e) Calculating a predicted temperature 41 and a standard deviation 42 using the machine learning model 40,

f) determining the degradation of a battery module 110 using predicted temperature 41, the standard deviation 42 and the actual temperature 11.

The machine learning model 40 is a random forest regression tree.

A change over the time of a probability of measuring the actual module temperature 11 (i.e. $T_{act}$), which is normal distributed, is an indicator for the degradation of the battery module 110.

The actual module temperature 11 (i.e. $T_{act}$) can be captured directly at the battery module 110 by one or more temperature sensors attached to specific battery cells of the battery module 110.

$Pr(X = T_{act})$ is the probability of measuring an module or cell temperature $T_{act}$ with a given normal distribution $X \sim \mathcal{N}(T_{pred}, \sigma_T)$, where $X$ is a normal distributed random variable with the mean 41 (i.e. $T_{pred}$) and the standard deviation 42 (i.e. $\sigma_T$).

The change over time of the probability $Pr(X = T_{act})$ is an indicator for the degradation of the battery module 110, because $X$ is a normal distribution of the predicted temperature $T_{pred}$, derived from observing the actual temperature $T_{act}$.

Degradation is most commonly associated with increased resistance and therefore increased joule heating. Thus, the degradation can be derived from the actual module or cell temperature.

If the probablity of observing $T_{act}$ is low, then the term $Pr(X = T_{act})$ will go to zero or some very small positive value and the degradation will only increase by a large amount.

$$\left(1 - Pr(X = T_{act})\right) \sim 1$$

Further, if the probablity of observing such a temperature on a non-degraded battery is very high, the term can be formulated:

$$\left(1 - Pr(X = T_{act})\right) \sim 0$$

A machine learning algorithm can be built based on the features of the load parameter set to model the normal behavior (temperature) of the battery cells during operation.

With the model the temperature 41 ($T_{pred}$) at any given time during the operation of the battery can be estimated.

Based on the historic data acquired from the battery the standard deviation interval 42 (i.e. $\sigma_T$) can be applied to the estimated temperature 41 (i.e. $T_{pred}$) which defines our confidence bound on the predicted value.

At a range approval step 50 it is calculated, whether the actual temperature $T_{act}$ is within the interval $T_{pred} \pm \sigma_T$.

If the approval 50 has as a result 51 "YES", then the method will be repeated, and the battery monitoring is continued.

If the approval 50 has as a result 52 "NO", then a degradation parameter 60 is calculated.

The degradation can be represented as $D_N$ at the $N^{th}$ measurement of the degradation.

If subsequently remeasured values of the temperature are within the interval, the degradation is considered as non-significant.

If subsequently remeasured values of the temperature are outside the interval, the level of degradation is increased and considered as significant.

In an exemplary implementation,

$$D_N = D_{N-1} + \lambda \cdot \left(1 - Pr(X = T_{act})\right)$$

where

$Pr(X = T_{act})$      is the probability of measuring a temperature with a given

$$X \sim \mathcal{N}(T_{pred}, \sigma_T),$$

$D_0 = 0$      is the baseline degradation in health at the time of production, and

$\lambda \geq 1$      is a configurable parameter that is used to set how conservative the algorithm is in terms of adding degradation to the system.

Increases in $D$ over time, i.e. the change over the time of the probability of measuring the actual module or cell temperature 11, can be tracked until the degradation exceeds a predefined threshold

$$|D_N| > D_{Threshold}$$

where

$D_{Threshold}$      is a prescribed cutoff value, in which the health of the battery has degraded beyond a tolerated safety margin.

Thus, at a threshold approval step 70 it is calculated, whether the degradation parameter is below a predefined threshold.

If the approval 70 has as a result 71 "YES", then a step of storing degradation parameter 80 is performed. Stored degradation parameters can be used at the setup and training of the machine learning model.

If the approval 70 has as a result 72 "NO", then a warning signal 90 to an operator can be made, since the degradation of the battery module 110 has reached a critical stage.

Appropriate action steps, for instance raising an alarm based on the usage scenario and relevant regulations can be further made.

**Fig. 3** shows an example of the sequence of the steps of the method, but alternative sequences will also work, like parallel steps a) to c).

**List of reference numerals:**

| | |
|---|---|
| 10 | battery parameter set |
| 11 | battery module/ cell temperature |
| 12 | battery module/ cell voltage |
| 13 | battery module/ cell current |
| 20 | load parameter set |
| 21 | inverter power consumption |
| 22 | AC current of motor (RMS) |
| 23 | current at d-axis of the motor |
| 24 | current at q-axis of the motor |
| 25 | DC current of motor |
| 26 | rotational speed of motor |
| 27 | motor torque |
| 30 | environmental parameter set |
| 31 | ambient air temperature |
| 40 | machine learning model |
| 41 | predicted temperature |
| 42 | standard deviation |
| 50 | parameter range approval |
| 51, 71 | Yes |
| 52, 72 | No |
| 60 | calculate degradation parameter |
| 70 | degradation parameter below threshold? |
| 80 | store degradation parameter |
| 90 | raise alarm |
| 100 | battery monitor device |
| 110 | battery module |
| 120 | load device |
| 121 | inverter |
| 122 | motor |

**Claims**

1. Method for determining the degradation of a battery module (110) or a battery cell, wherein the battery module (110) or battery cell delivers energy to an electric load (120), and following steps are comprised:

   a) Capturing a battery parameter set (10) comprising an actual temperature (11) of the battery module (110) or cell,
   b) Capturing a load parameter set (20) of the load (120),
   c) Capturing an environmental parameter set (30) of the environment of the battery module (110) or cell,
   d) Setup and training a machine learning model (40) with the battery parameter set (10), the load parameter set (20) and the environmental parameter set (30),
   e) Calculating a predicted temperature (41) and a standard deviation (42) using the machine learning model (40),
   f) determining the degradation of a battery module (110) using predicted temperature (41), the standard deviation (42) and the actual temperature (11),

   **characterized in that** a change over the time of a probability of measuring the actual module or cell temperature (11), which is normal distributed, is an indicator for the degradation of the battery module or battery cell.

2. Method according to the preceding claim, wherein the battery parameter set (10), the load parameter set (20) and the environmental parameter set (30) are captured during energy delivery of the battery module (110) or battery cell.

3. Method according to one of the preceding claims, wherein the battery parameter set (10) comprises at least one parameter related to at least one voltage (12) and/or at least one current (13) of the battery module (110) or at least one cell of the battery module (110).

4. Method according to one of the preceding claims, wherein the electric load (120) comprises an inverter (121), and the load parameter set (20) comprises a parameter related to the power consumption (21) of the inverter (121).

5. Method according to one of the preceding claims, wherein the electric load (120) comprises an electric motor (122), and the load parameter set (20) comprises at least one parameter related to at least one current (22-25), at least one voltage, a rotational speed (26), a magnetic flux and/or a motor torque (27) of the electric motor (122).

6. Method according to one of the preceding claims, wherein the environmental parameter set (30) comprises at least one parameter related to an ambient air temperature (31) in proximity of the battery module (110).

7. Method according to one of the preceding claims, wherein the machine learning model (40) is a random forest regression tree.

8. Device (100) for determining the degradation of a connected battery module (110) or a connected battery cell, **characterized in that** the battery module (110) or battery cell is configured to deliver energy to a connected electric load (120), and the battery monitor device (100) is configured to carry out the method according to one of the preceding claims.

**Patentansprüche**

1. Verfahren zum Bestimmen der Degradation Leistungsverlusts eines Batteriemoduls (110) oder einer Batteriezelle, wobei das Batteriemodul (110) oder die Batteriezelle Energie an einen elektrischen Verbraucher (120) abgibt und folgende Schritte enthalten sind:

a) Erfassen eines Batterieparametersatzes (10), der eine Ist-Temperatur (11) des Batteriemoduls (110) oder der Batteriezelle umfasst,
b) Erfassen eines Verbraucherparametersatzes (20) des Verbrauchers (120),
c) Erfassen eines Umgebungsparametersatzes (30) der Umgebung des Batteriemoduls (110) oder der Batteriezelle,
d) Einrichten und Trainieren eines Maschinenlernmodells (40) mit dem Batterieparametersatz (10), dem Verbraucherparametersatz (20) und dem Umgebungsparametersatz (30),
e) Berechnen einer prognostizierten Temperatur (41) und einer Standardabweichung (42) mithilfe des Maschinenlernmodells (40),
f) Bestimmen der Degradation eines Batteriemoduls (110) unter Verwendung der prognostizierten Temperatur (41), der Standardabweichung (42) und der Ist-Temperatur (11),

**dadurch gekennzeichnet, dass** eine Änderung einer Wahrscheinlichkeit eines Messens der Modul- oder Zellen-Ist-Temperatur (11) mit der Zeit, die normal verteilt ist, ein Indikator für die Degradation des Batteriemoduls oder der Batteriezelle ist.

2. Verfahren nach dem vorhergehenden Anspruch, wobei der Batterieparametersatz (10), der Verbraucherparametersatz (20) und der Umgebungsparametersatz (30) bei der Energieabgabe des Batteriemoduls (110) oder der Batteriezelle erfasst werden.

3. Verfahren nach einem der vorhergehenden Ansprüche, wobei der Batterieparametersatz (10) mindestens einen Parameter umfasst, der mindestens eine Spannung (12) und/oder mindestens einen Strom (13) des Batteriemoduls (110) oder mindestens einer Batteriezelle des Batteriemoduls (110) betrifft.

4. Verfahren nach einem der vorhergehenden Ansprüche, wobei der elektrische Verbraucher (120) einen Wechselrichter (121) und der Verbraucherparametersatz (20) einen Parameter umfasst, der den Stromverbrauch (21) des Wechselrichters (121) betrifft.

5. Verfahren nach einem der vorhergehenden Ansprüche, wobei der elektrische Verbraucher (120) einen Elektromotor (122) und der Verbraucherparametersatz (20) mindestens einen Parameter umfasst, der mindestens einen Strom (22-25), mindestens eine Spannung, eine Drehzahl (26), einen Magnetfluss und/oder ein Motordrehmoment (27) des Elektromotors (122) betrifft.

6. Verfahren nach einem der vorhergehenden Ansprüche, wobei der Umgebungsparametersatz (30) mindestens einen Parameter umfasst, der eine Umgebungslufttemperatur (31) in der Nähe des Batteriemoduls (110) betrifft.

7. Verfahren nach einem der vorhergehenden Ansprüche, wobei es sich bei dem Maschinenlernmodell (40) um einen Random-Forest-Entscheidungsbaum handelt.

8. Vorrichtung (100) zum Bestimmen der Degradation eines angeschlossenen Batteriemoduls (110) oder einer angeschlossenen Batteriezelle, **dadurch gekennzeichnet, dass** das Batteriemodul (110) oder die Batteriezelle so konfiguriert ist, dass es/sie Energie an einen angeschlossenen elektrischen Verbraucher (120) abgibt, und die Batterieüberwachungsvorrichtung (100) so konfiguriert ist, dass sie das Verfahren nach einem der vorhergehenden Ansprüche ausführt.

## Revendications

1. Procédé pour déterminer la dégradation d'un module de batterie (110) ou d'un élément de batterie, dans lequel le module de batterie (110) ou l'élément de batterie fournit de l'énergie à une charge électrique (120), et les étapes suivantes sont comprises :

   a) la capture d'un ensemble de paramètres de batterie (10) comprenant une température réelle (11) du module de batterie (110) ou de l'élément,
   b) la capture d'un ensemble de paramètres de charge (20) de la charge (120),
   c) la capture d'un ensemble de paramètres environnementaux (30) de l'environnement du module de batterie (110) ou de l'élément,
   d) la mise en place et l'entraînement d'un modèle d'apprentissage automatique (40) avec l'ensemble de paramètres de batterie (10), l'ensemble de paramètres de charge (20) et l'ensemble de paramètres environnementaux (30),
   e) le calcul d'une température prédite (41) et d'un écart type (42) à l'aide du modèle d'apprentissage automatique (40),
   f) la détermination de la dégradation d'un module de batterie (110) à l'aide de la température prédite (41), de l'écart type (42) et de la température réelle (11),

   **caractérisé en ce qu'**une variation au cours du temps d'une probabilité de mesure de la température réelle (11) du module ou de l'élément, qui suit une distribution normale, est un indicateur pour la dégradation du module de batterie ou de l'élément de batterie.

2. Procédé selon la revendication précédente, dans lequel l'ensemble de paramètres de batterie (10), l'ensemble de paramètres de charge (20) et l'ensemble de paramètres environnementaux (30) sont capturés pendant une fourniture d'énergie du module de batterie (110) ou de l'élément de batterie.

3. Procédé selon l'une des revendications précédentes, dans lequel l'ensemble de paramètres de batterie (10) comprend au moins un paramètre se rapportant à au moins une tension (12) et/ou à au moins un courant (13) du module de batterie (110) ou d'au moins un élément du module de batterie (110).

4. Procédé selon l'une des revendications précédentes, dans lequel la charge électrique (120) comprend un onduleur (121), et l'ensemble de paramètres de charge (20) comprend un paramètre se rapportant à la consommation électrique (21) de l'onduleur (121) .

5. Procédé selon l'une des revendications précédentes, dans lequel la charge électrique (120) comprend un moteur électrique (122), et l'ensemble de paramètres de charge (20) comprend au moins un paramètre se rapportant à au moins un courant (22-25), à au moins une tension, à une vitesse de rotation (26), à un flux magnétique et/ou à un couple moteur (27) du moteur électrique (122).

6. Procédé selon l'une des revendications précédentes, dans lequel l'ensemble de paramètres environnementaux (30) comprend au moins un paramètre se rapportant à une température d'air ambiant (31) à proximité du module de batterie (110).

7. Procédé selon l'une des revendications précédentes, dans lequel le modèle d'apprentissage automatique (40) est un arbre de régression de forêt aléatoire.

8. Dispositif (100) pour déterminer la dégradation d'un module de batterie (110) connecté ou d'un élément de batterie connecté, **caractérisé en ce que** le module de batterie (110) ou l'élément de batterie est configuré pour fournir de l'énergie à une charge électrique (120) connectée, et le dispositif de surveillance de batterie (100) est configuré pour mettre en œuvre le procédé selon l'une des revendications précédentes.

## FIG 1

## FIG 2

FIG 3

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2016349330 A1
- US 2017104332 A1
- WO 2019017991 A1
- US 2019113577 A1